# FASCICULE DE BREVET EUROPEEN

(11) **EP 3 314 281 B1**
(45) Date de publication et mention de la délivrance du brevet: **18.09.2019**
(21) Numéro de dépôt: 16739207.5
(22) Date de dépôt: 10.06.2016
(51) Int. Cl.: G01R 33/04, G01R 15/18

(54) **APPAREIL POUR MESURER UN CHAMP MAGNETIQUE**
VORRICHTUNG ZUR MESSUNG EINES MAGNETFELDES
DEVICE FOR MEASURING A MAGNETIC FIELD

(30) Priorité: 26.06.2015 FR 1555928
(43) Date de publication de la demande: 02.05.2018
(73) Titulaire: Atware, 92350 Le Plessis Robinson (FR)
(72) Inventeur: AUGAIS, Thierry, 91410 Saint Cyr Sous Dourdan (FR)
(74) Mandataire: Cabinet Plasseraud
(86) Numéro de dépôt international: PCT/FR2016/051397
(87) Numéro de publication internationale: WO 2016/207508

(56) Documents cités:
- EP-A2- 1 262 766
- US-A1- 2009 143 665
- US-A1- 2014 253 113
- US-A1- 2015 108 974
- ERIC VOURC'H ET AL: "Neel Effect Toroidal Current Sensor", IEEE TRANSACTIONS ON MAGNETICS, IEEE SERVICE CENTER, NEW YORK, NY, US, vol. 49, no. 1, 1 janvier 2013 (2013-01-01), pages 81-84, XP011483180, ISSN: 0018-9464, DOI: 10.1109/TMAG.2012.2222021

## Description

La présente invention concerne un appareil de mesure d'un champ magnétique, ainsi que des procédés qui utilisent un tel appareil pour mesurer un champ magnétique ou un courant continu.

De nombreuses applications nécessitent de mesurer un champ magnétique, soit parce que la valeur du champ magnétique est recherchée par elle-même, soit parce qu'elle donne accès à la valeur d'une autre grandeur physique qui est recherchée. Notamment, il est connu que la valeur d'un courant continu puisse être déduite d'une mesure du champ magnétique qui est généré par ce courant continu.

Les documents EP 1 262 766 B1, EP 2 120 041 B1 et FR 2 914 060 B1 concernent des appareils de mesure de quantités de matériau magnétique, pour lesquels le matériau magnétique appartient aux échantillons mesurés et non à chaque appareil de mesure, et pour lesquels la précision et la fiabilité des mesures peuvent être réduites à cause du mode de connexion de chaque bobine aux moyens d'injection des courants mis en oeuvre et aux moyens de détection.

Mais il existe toujours un besoin important pour des appareils de mesure de champ magnétique qui soient améliorés, notamment sur les critères suivants :
- l'appareil permet des mesures précises et fiables ;
- l'appareil peut être fabriqué à coût réduit ;
- l'appareil provoque une consommation énergétique qui est faible pour réaliser chaque mesure ;
- les résultats des mesures qui sont effectuées avec l'appareil ne sont pas affectés, ou sont peu affectés, par des décalages involontaires de signaux, appelés offsets ;
- les mesures qui sont effectuées avec l'appareil présentent un rapport signal-sur-bruit qui est élevé ;
- l'appareil produit des résultats de mesures qui sont robustes par rapport à des perturbations électromagnétiques extérieures ; et
- l'appareil doit satisfaire les exigences réglementaires de compatibilité électromagnétique (compatibilité CEM).

Pour améliorer ces critères par rapport aux appareils existants, un premier aspect de la présente invention propose un nouvel appareil pour mesurer un champ magnétique, qui comprend :
- quatre bobines de fil électrique à noyaux superparamagnétiques, les quatre bobines à noyaux possédant des géométries et des propriétés électriques et électromagnétiques qui sont identiques ou sensiblement identiques, et les quatre bobines étant connectées électriquement en série de façon à former une chaîne avec deux bornes extrêmes de la chaîne, une borne centrale dans la chaîne, et deux bornes secondaires de la chaîne qui sont situées chacune entre la borne centrale et l'une des deux bornes extrêmes ;
- des moyens d'injection d'un courant continu dans la chaîne des bobines, qui sont connectés aux deux bornes extrêmes de la chaîne des bobines, et des moyens d'ajustement d'une intensité du courant continu ;
- des moyens d'injection d'un premier courant alternatif ayant une première fréquence, qui sont connectés pour injecter le premier courant alternatif dans la chaîne des bobines par la borne centrale, et pour reprendre ce premier courant alternatif par les deux bornes extrêmes, de sorte que le premier courant alternatif s'écoule avec des premières intensités qui sont identiques ou sensiblement identiques par les deux bornes extrêmes sans s'écouler par les bornes secondaires ;
- des moyens d'injection d'un second courant alternatif ayant une seconde fréquence différente de la première fréquence, ces moyens d'injection du second courant alternatif étant connectés pour injecter le second courant alternatif dans la chaîne des bobines par les deux bornes secondaires, et pour reprendre le second courant alternatif par la borne centrale et les deux bornes extrêmes de sorte que le second courant alternatif s'écoule avec des secondes intensités qui sont identiques ou sensiblement identiques par les deux bornes secondaires, et qu'il s'écoule avec des troisièmes intensités qui sont identiques ou sensiblement identiques dans toutes les bobines mais en sens contraires entre deux bobines qui sont successives dans la chaîne ; et
- des moyens de détection d'au moins une composante de tension électrique qui existe entre les deux bornes secondaires de la chaîne des bobines, une fréquence de cette composante de tension électrique, dite fréquence de mélange, étant une combinaison linéaire de la première fréquence et de la seconde fréquence, avec des coefficients de combinaison linéaire qui sont fixes, entiers et non nuls.

L'appareil de l'invention est adapté pour activer simultanément les moyens d'injection des premier et second courants alternatifs, et pour ajuster l'intensité du courant continu de façon à annuler une amplitude de la composante de tension électrique qui possède la fréquence de mélange, pendant que les premier et second courants alternatifs sont injectés. Ainsi, lorsque les quatre bobines sont placées dans le champ magnétique, une valeur de l'intensité du courant continu qui annule l'amplitude de la composante de tension électrique possédant la fréquence de mélange, est proportionnelle à une intensité du champ magnétique.

Dans le cadre de l'invention, on entend par matériau superparamagnétique un matériau magnétique non-linéaire qui ne présente pas d'hystérèse lorsque l'excitation magnétique, ou champ magnétique, qui est appliquée à ce matériau est variée périodiquement.

Dans l'appareil de l'invention, le matériau superparamagnétique des noyaux est utilisé comme révélateur d'un champ magnétique permanent total qui n'est pas nul à l'intérieur des bobines. Ce champ magnétique permanent total est la somme du champ magnétique à mesurer, qui est supposé permanent, ou statique, et d'un champ magnétique de compensation qui est produit par le courant continu injecté dans les bobines. Or le matériau superparamagnétique présente un comportement non-linéaire vis-à-vis des premier et second courants alternatifs dès que le champ magnétique permanent total n'est pas nul, alors que ce comportement devient sensiblement linéaire si le champ magnétique permanent total est nul. Grâce à cela, la nullité du champ magnétique permanent total est détectée par les moyens de détection, à travers la nullité de la composante de tension électrique à la fréquence de mélange. En connaissant la relation entre le courant continu qui est injecté dans les bobines et le champ magnétique de compensation qui est produit par ce courant continu, par étalonnage ou par calcul, la valeur de ce courant continu qui produit l'annulation de la composante de tension électrique à la fréquence de mélange, fournit une valeur pour le champ magnétique à mesurer. Autrement dit, l'appareil de l'invention utilise un principe de mesure par compensation, pour laquelle la nullité de la composante de tension à la fréquence de mélange constitue un indicateur de compensation exacte.

Un tel appareil peut être fabriqué en utilisant des composants électriques qui sont disponibles commercialement à faibles coûts, notamment parce qu'ils sont déjà produits en grandes séries pour d'autres applications.

La connexion des moyens d'injection du courant continu aux bobines, celles des moyens d'injection des premier et second courants alternatifs, ainsi que la connexion des moyens de détection, réduisent ou suppriment par leurs sens de connexion des contributions dans le signal qui est transmis aux moyens de détection qui seraient dues aux premier et second courants alternatifs. La détection de la composante de tension électrique à la fréquence de mélange est alors plus précise et plus fiable.

De plus, les moyens d'injection des courants peuvent être sélectionnés ou conçus aisément pour garantir la compatibilité électromagnétique.

Par ailleurs, un quotient entre les première et seconde fréquences peut être préférablement supérieur à 10, pour que les moyens de détection de la composante de tension électrique à la fréquence de mélange isolent cette composante avec une efficacité supérieure.

Dans des réalisations préférées d'un appareil conforme à l'invention, les moyens d'injection du courant continu, les moyens d'injection du premier courant alternatif et les moyens d'injection du second courant alternatif peuvent comprendre ensemble quatre câbles de connexion qui sont dédiés respectivement à chacune des quatre bobines. Chacun des câbles comprend deux fils électriques qui sont connectés un-à-une aux deux bornes successives dans la chaîne des bobines qui connectent directement la bobine à laquelle ce câble est dédié. Ainsi, tout le courant continu, tout le premier courant alternatif et tout le second courant alternatif qui sont injectés dans les bobines sont transportés en aller et retour par les quatre câbles. Alors, des longueurs respectives des quatre câbles peuvent être ajustées pour que les troisièmes intensités du second courant alternatif soient identiques ou sensiblement identiques en valeur absolue dans toutes les bobines de la chaîne. En outre, le transfert d'énergie électrique aux bobines, à partir des moyens d'injection du courant alternatif qui possède la fréquence la plus élevée, peut être amélioré de cette façon. La consommation énergétique de l'appareil, pour une sensibilité de mesure identique, peut ainsi être diminuée.

Par ailleurs, lorsque la seconde fréquence est supérieure à la première fréquence, les moyens d'injection du second courant alternatif peuvent comprendre une source du second courant alternatif et un enroulement primaire d'un transformateur, avec une sortie de courant de la source qui est connectée à un point milieu de l'enroulement primaire du transformateur. Les deux bornes extrêmes de l'enroulement primaire sont alors connectées respectivement aux deux bornes secondaires de la chaîne des bobines, et un enroulement secondaire du transformateur appartient aux moyens de détection de la composante de tension électrique qui possède la fréquence de mélange. Dans une telle réalisation, la tension qui est transmise aux moyens de détection possède, par conception de l'appareil, des composantes aux première et seconde fréquences qui ont des amplitudes nulles. Pour cette raison, l'appareil de l'invention peut être dit auto-compensé par rapport à des contributions éventuelles des signaux d'excitation aux première et seconde fréquences dans le signal qui est détecté. La composante de la fréquence de mélange peut ainsi être isolée avec une efficacité et une pureté qui sont supérieures.

En particulier pour obtenir un rapport signal-sur-bruit qui est supérieur, les moyens de détection de la composante de tension électrique qui possède la fréquence de mélange, dans un appareil conforme à l'invention, peuvent comprendre :
- un premier démodulateur synchrone qui est couplé aux moyens d'injection du second courant alternatif, et qui est agencé pour décaler en fréquence la composante de tension électrique qui possède la fréquence de mélange, par suppression d'une contribution de la seconde fréquence dans cette fréquence de mélange ; et
- un second démodulateur synchrone qui est couplé aux moyens d'injection du premier courant alternatif, et qui est agencé pour décaler en fréquence la composante de tension électrique qui possède la fréquence de mélange, par suppression d'une contribution de la première fréquence dans cette fréquence de mélange.

Ces premier et second démodulateurs synchrones sont alors agencés en cascade pour produire en sortie un signal électrique continu qui est proportionnel à une amplitude de la composante de tension électrique qui possède la fréquence de mélange. Ce signal constitue le signal de détection, après amplification éventuelle. En outre, lorsque la seconde fréquence est supérieure à la première fréquence, les moyens d'injection du second courant alternatif peuvent comprendre des moyens pour multiplier une intensité instantanée du second courant alternatif par une séquence pseudo-aléatoire de facteurs chacun égaux à +1 ou -1, de façon à créer une modulation du second courant alternatif qui est aussi supprimée par le premier démodulateur synchrone. Le rapport signal-sur-bruit de l'appareil peut encore être augmenté de cette façon.

Eventuellement, pour augmenter encore la sensibilité des moyens de détection, ceux-ci peuvent être adaptés pour détecter une association de deux composantes de la tension alternative qui existe entre les deux bornes secondaires de la chaîne des bobines, correspondant à deux fréquences de mélange distinctes. Toutefois, dans un tel cas, ces deux composantes ont des contributions qui sont opposées pour la plus basse entre la première et la seconde fréquence dans les combinaisons linéaires qui constituent les deux fréquences de mélange, et des contributions qui sont identiques pour la plus élevée entre la première et la seconde fréquence.

De façon générale lorsque la seconde fréquence est supérieure à la première fréquence, les moyens d'injection du premier courant alternatif peuvent être connectés à la borne centrale de la chaîne des bobines par un premier condensateur qui est adapté pour être conducteur de courant alternatif à la première fréquence et à la seconde fréquence. Simultanément, les moyens d'injection du second courant alternatif peuvent être connectés à chacune des deux bornes secondaires de la chaîne des bobines par un second condensateur respectif qui est adapté pour être conducteur de courant alternatif à la seconde fréquence mais pas à la première fréquence. Une telle réalisation de l'appareil contribue à assurer la répartition dans les quatre bobines qui est voulue pour le courant continu, le premier courant alternatif et le second courant alternatif.

La disposition des quatre bobines les unes par rapport aux autres, ainsi que leurs sens d'enroulement respectifs pour le fil électrique, peuvent être avantageusement adaptés à la géométrie et aux symétries du champ magnétique à mesurer. Ainsi, la sensibilité de l'appareil au champ magnétique à mesurer peut être améliorée, alors que sa sensibilité à des champs magnétiques parasites qui n'ont pas de lien avec le champ magnétique à mesurer, peut être diminuée.

Un deuxième aspect de l'invention propose un procédé pour mesurer un champ magnétique, qui comprend les étapes suivantes :
/1/ placer les quatre bobines d'un appareil qui est conforme au premier aspect de l'invention, dans un champ magnétique ; et
/2/ activer simultanément les moyens d'injection des premier et second courants alternatifs, et ajuster l'intensité du courant continu qui est produite par les moyens d'injection de courant continu de façon à annuler l'amplitude de la composante de tension électrique qui possède la fréquence de mélange, pendant que les premier et second courants alternatifs sont injectés.

Alors, la valeur de l'intensité du courant continu qui est produite par les moyens d'injection de courant continu et qui a été ajustée à l'étape /2/ constitue un résultat de mesure pour le champ magnétique.

Un troisième aspect de l'invention propose un procédé pour mesurer un courant électrique continu, qui comprend les étapes suivantes :
/1/ fournir un appareil qui est conforme au premier aspect de l'invention ;
/2/ disposer les quatre bobines à proximité du courant électrique continu qui est à mesurer, appelé courant inconnu, ou bien autour de ce courant inconnu de sorte que ce courant inconnu passe à travers les boucles des quatre noyaux à l'extérieur des bobines ; et
/3/ activer simultanément les moyens d'injection des premier et second courants alternatifs, et ajuster l'intensité du courant continu qui est produit par les moyens d'injection de courant continu dans la chaîne des bobines, de façon à annuler l'amplitude de la composante de tension électrique qui possède la fréquence de mélange, pendant que les premier et second courants alternatifs sont injectés.

Alors, la valeur de l'intensité du courant continu qui est produite par les moyens d'injection de courant continu et qui a été ajustée à l'étape /3/, constitue un résultat de mesure pour le courant inconnu.

D'autres particularités et avantages de la présente invention apparaîtront dans la description ci-après d'exemples de réalisation non limitatifs, en référence aux dessins annexés, dans lesquels :
- les figures 1a, 1b et 1c sont des vues en perspective de trois configurations possibles pour les quatre bobines d'un appareil conforme à l'invention ;
- la figure 2 est un schéma synoptique d'un appareil conforme à l'invention ; et
- la figure 3 correspond à la figure 2 pour des réalisations particulières des moyens d'injection de courants.

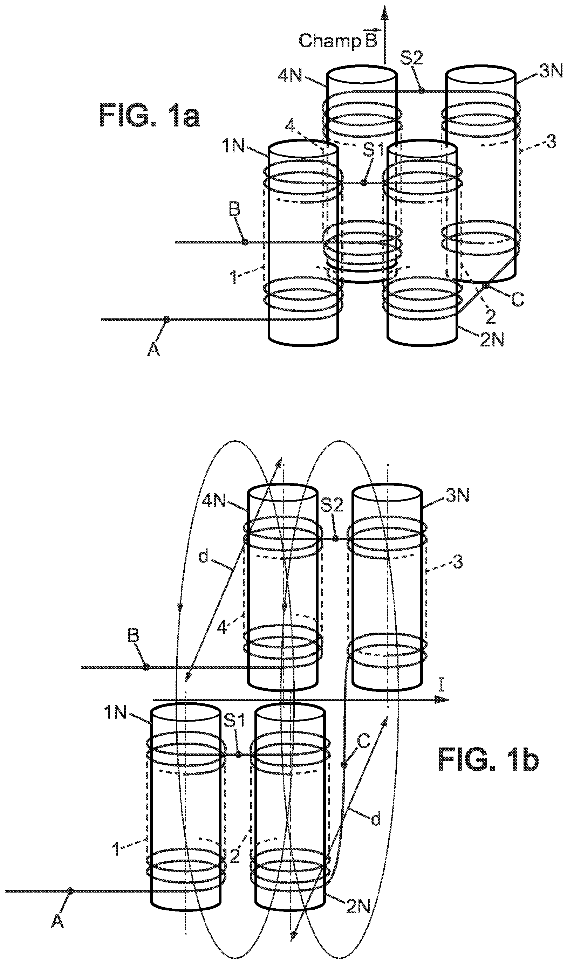

Pour raison de clarté des figures 1a-1c, les dimensions apparentes des éléments qui y sont représentés ne correspondent ni à des dimensions réelles ni à des rapports de dimensions réels. En outre, des références identiques qui sont indiquées dans des figures différentes désignent des éléments identiques ou qui ont des fonctions identiques.

Dans les figures 1a-1c, les références 1 à 4 désignent quatre bobines de fil électrique qui sont conçues pour être identiques. Les références 1N à 4N désignent quatre noyaux de matériau superparamagnétique qui sont conçus pour être identiques, et sont placés chacun dans l'une des bobines 1 à 4, de la même façon pour toutes les bobines.

Les bobines 1 à 4 sont connectées électriquement en série. A et B désignent respectivement les bornes extrêmes de la connexion en série des bobines 1-4, la borne A étant du côté de la bobine 1 et la borne B du côté de la bobine 4. S1 et S2, dites bornes secondaires, sont respectivement intermédiaires entre les bobines 1 et 2, et entre les bobines 3 et 4, et C, dite borne centrale, est intermédiaire entre les bobines 2 et 3.

Dans la configuration de la figure 1a, les quatre bobines 1-4 sont toutes parallèles à un axe commun, qui est vertical sur la figure. Elles sont juxtaposées les unes aux autres et ont des sens d'enroulement respectifs du fil électrique autour des noyaux N1-N4 qui sont identiques par rapport à l'axe commun. Cette première configuration est adaptée pour mesurer un champ magnétique qui est sensiblement uniforme dans la portion d'espace qui est occupée par les quatre bobines à noyaux. Le champ magnétique à mesurer est noté Champ **B** sur la figure 1a. Pour sa mesure, l'ensemble des quatre bobines à noyaux doit être amené dans la zone du champ magnétique et orienté pour que l'axe commun des bobines 1-4 et des noyaux N1-N4 soit parallèle au champ magnétique à mesurer.

Dans la configuration de la figure 1b, les quatre bobines 1-4 sont encore toutes parallèles à un axe commun, qui est vertical sur la figure. Mais elles sont réparties en deux paires de bobines, avec les bobines d'une même paire qui ont des sens d'enroulement du fil électrique autour des noyaux qui sont identiques pour les deux bobines de cette paire, et inverses au sens d'enroulement des bobines de l'autre paire. En outre, les bobines d'une même paire sont juxtaposées alors que les deux paires de bobines sont distantes l'une de l'autre perpendiculairement à l'axe commun. Dans la figure 1b, les bobines 1 et 2 constituent ensemble la première paire, et les bobines 3 et 4 constituent ensemble la seconde paire. d est la distance de séparation entre les deux paires. Cette deuxième configuration est adaptée pour mesurer un champ magnétique qui est inversé, mais égal en module, entre l'endroit de la première paire et celui de la seconde paire. Elle est adaptée en particulier pour mesurer le champ magnétique qui est produit par un courant électrique noté I, dont la trajectoire est rectiligne et centrée entre les deux paires de bobines, perpendiculaire à l'axe commun des bobines et aussi à la direction de séparation des deux paires de bobines. Les ellipses qui sont dessinées sur la figure 1b sont des lignes de champ du champ magnétique **B** qui est créé par le courant I. Ces lignes de champ sont des cercles dans l'espace qui ont pour axe la trajectoire du courant I, et qui apparaissent comme des ellipses dans la vue en perspective. Une telle configuration permet de compenser entre les deux paires de bobines des tensions électriques parasites qui sont induites par des rayonnements électromagnétiques externes. Evidemment, la configuration de la figure 1b peut être modifiée par équivalence en faisant glisser l'une des paires le long des lignes du champ magnétique, de sorte que les bobines de cette paire restent parallèles aux lignes de champ à l'endroit de la paire.

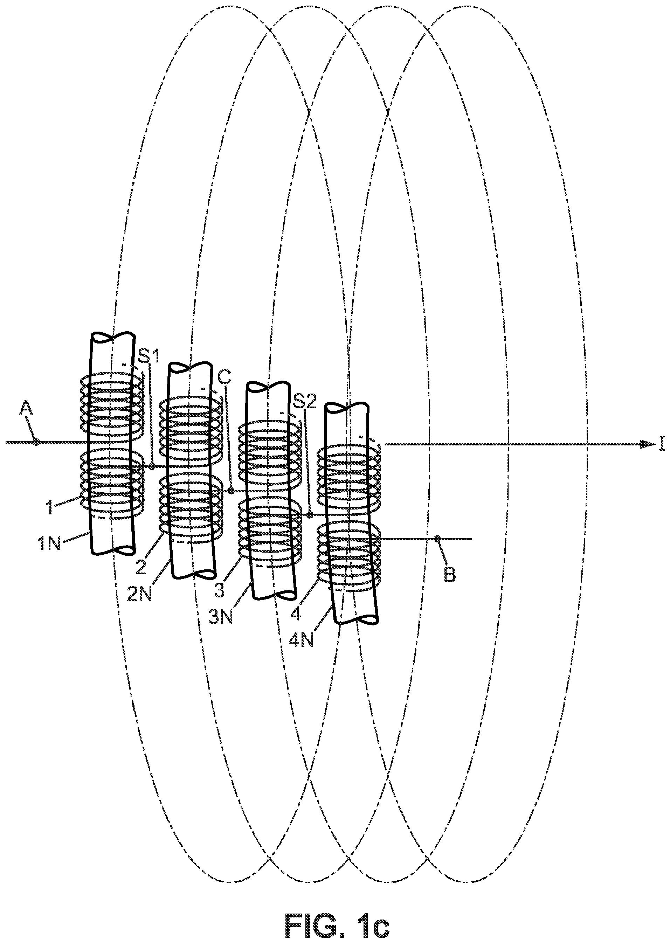

Dans la configuration de la figure 1c, chaque noyau 1N-4N est en forme de boucle fermée et chaque bobine 1-4 est enroulée sur le noyau de cette bobine perpendiculairement à une direction longitudinale de la boucle. En outre, les quatre bobines à noyaux sont juxtaposées les unes aux autres sur toute une longueur de boucle des noyaux, et ont des sens d'enroulement du fil électrique qui sont identiques. Cette troisième configuration est adaptée pour mesurer des champs magnétiques qui ont des répartitions similaires à celle qui vient d'être décrite en référence à la figure 1b. En particulier, elle est adaptée pour mesurer le champ magnétique qui est créé par un courant I dont la trajectoire est superposée à l'axe des boucles qui sont constituées par les noyaux. Cette troisième configuration assure que des rayonnements électromagnétiques externes n'ont presqu'aucune influence sur les résultats de mesures fournis par l'appareil de l'invention.

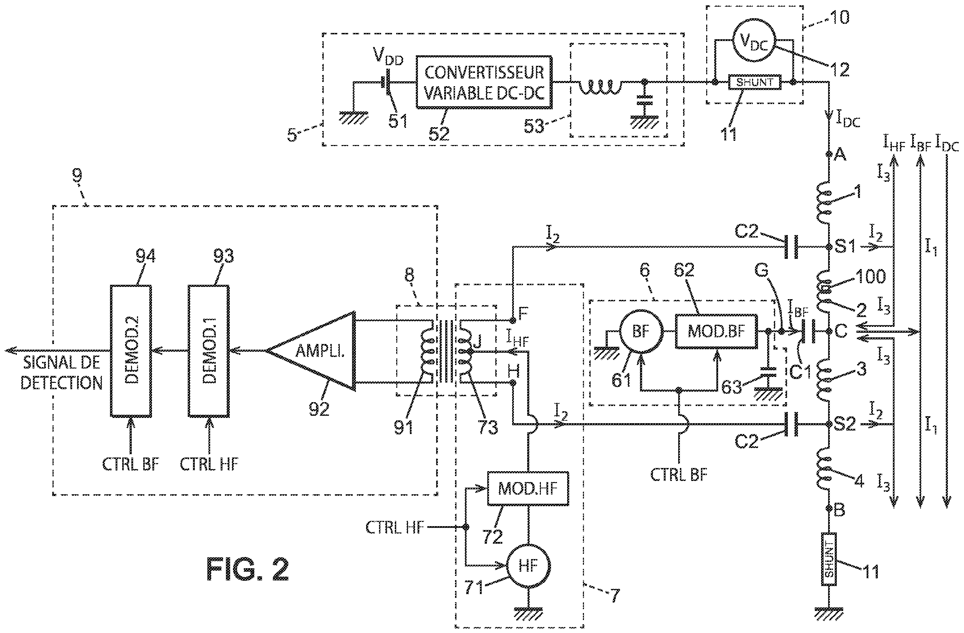

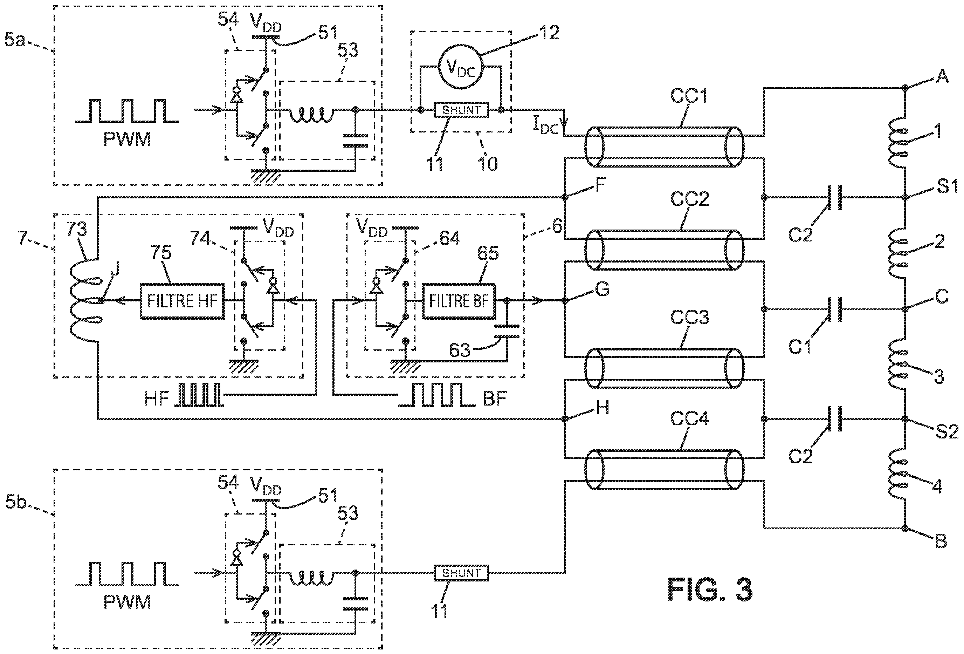

Les désignations qui ont été utilisées dans la partie générale de la présente description ont les correspondances suivantes avec celles du mode de réalisation des figures 2 et 3 : la première fréquence peut être égale à 1 kHz par exemple et est notée BF, et la seconde fréquence peut être égale à 200 kHz et est notée HF. Ces valeurs pour les fréquences BF et HF permettent d'utiliser des filtres qui sont disponibles commercialement, notamment pour des applications radio. Le premier et le second courants alternatifs, qui possèdent respectivement les fréquences BF et HF, sont notés I_{BF} et I_{HF}. Le courant continu est noté I_{DC}.

Les références suivantes qui sont indiquées dans la figure 2 ont les significations données ci-dessous :
5 générateur du courant continu I_{DC}, appelé moyens d'injection du courant continu ;
6 générateur du courant I_{BF}, appelé moyens d'injection du premier courant alternatif ;
7 générateur du courant I_{HF}, appelé moyens d'injection du second courant alternatif ;
8 transformateur, avec un enroulement primaire référencé 73 et un enroulement secondaire référencé 91 ;
9 moyens de détection d'une composante de tension alternative qui existe entre les bornes secondaires S1 et S2, avec une fréquence de mélange qui est une combinaison linéaire des fréquences BF et HF ;
10 moyens de mesure du courant continu ;
11 résistances électriques égales l'une à l'autre, notées SHUNT ;
12 moyens de mesure de la tension aux bornes de la résistance électrique 5, tels qu'un voltmètre continu noté V_{DC} ;
C1 condensateur dimensionné pour transmettre le courant I_{BF}, et qui transmet par conséquent aussi un courant à la fréquence HF ; et
C2 condensateurs dimensionnés pour transmettre des courants à la fréquence HF, mais pour empêcher des passages de courants à la fréquence BF.

Le générateur 5 peut être formé d'une source de tension continue 51, d'un convertisseur variable DC-DC 52 et d'un filtre 53. V_{DD} est la tension continue qui est produite par la source 51. Le convertisseur 52 peut être commandé par un opérateur pour ajuster la valeur de l'intensité du courant I_{DC}. Le filtre 53 assure que des courants aux fréquences BF et HF puissent s'écouler hors des bobines 1-4 par la borne extrême A. Le générateur 5 produit donc le courant I_{DC} avec une valeur d'intensité qui est ajustable à volonté.

La résistance 11 et le voltmètre 12 constituent ensemble les moyens 10 pour mesurer l'intensité I_{DC}. Ces moyens 10 sont avantageusement intercalés en série entre la sortie du générateur 5 et la borne A de la chaîne des bobines 1-4. Les deux résistances 11 disposées symétriquement au niveau des bornes A et B assurent que les courants alternatifs soient équilibrés dans les quatre bobines 1-4.

Le générateur 6 peut être formé d'une source de courant alternatif à la fréquence BF, référencée 61, et optionnellement d'un modulateur 62, noté MOD. BF. Lorsqu'il est utilisé, le modulateur 62 est connecté en série à la sortie de la source 61. CTRL BF désigne un signal de commande ou un signal de source du générateur 6. La sortie de la source 61, ou du modulateur 62, est connectée à la borne centrale C par l'intermédiaire du condensateur C1. Le condensateur 63 assure qu'un courant à la fréquence HF puisse s'écouler hors des bobines 1-4 par la borne C. Le générateur 6 produit le courant I_{BF}.

Le générateur 7 peut être formé d'une source de courant alternatif à la fréquence HF, référencée 71, optionnellement d'un modulateur 72, noté MOD. HF, et de l'enroulement primaire 73 du transformateur 8. Lorsqu'il est utilisé, le modulateur 72 est connecté en série à la sortie de la source 71. CTRL HF désigne un signal de commande ou un signal de source du générateur 7. La sortie de la source 71, ou du modulateur 72, est connectée à un point milieu J de l'enroulement primaire 73 du transformateur 8. Les bornes extrêmes F et H de l'enroulement primaire 73 sont connectées aux bornes secondaires S1 et S2 de la chaînes des bobines 1-4, respectivement, par l'intermédiaire des condensateurs C2. Le générateur 7 produit le courant I_{HF}.

Grâce à ces branchements, les quatre bobines 1-4 sont chacune parcourues par le courant continu I_{DC}, par une partie I₁ de l'intensité du courant I_{BF} et aussi par une partie I₃ de l'intensité du courant I_{HF}, avec les orientations de courants qui sont indiquées dans la partie droite de la figure 2. En outre, les parties d'intensités I₁ et I₃ des deux courants alternatifs sont : I₁ = I_{BF}/2 et I₃ = I_{HF}/4. De plus, le courant I_{HF} est injecté dans la chaîne des bobines 1-4 avec une intensité I₂ = I_{HF}/2 par chacune des bornes secondaires S1 et S2.

Les moyens de détection 9 comprennent l'enroulement secondaire 91 du transformateur 8, un amplificateur 92, noté AMPLI., un premier démodulateur synchrone 93, noté DEMOD. 1, et un second démodulateur synchrone 94, noté DEMOD. 2.

Le démodulateur synchrone 93 reçoit en entrée la tension qui existe aux bornes de l'enroulement secondaire 91, après amplification de cette tension, et reçoit simultanément le signal CTRL HF qui est introduit dans le générateur 7. Il est adapté pour effectuer un transfert de fréquence sur la composante de la tension dans l'enroulement secondaire 91 qui possède la fréquence HF-BF, et avantageusement aussi sur la composante de la même tension qui possède la fréquence HF+BF. De préférence, le démodulateur synchrone 93 peut être de type analogique. Lorsque le modulateur 72 est utilisé, la modulation du courant I_{HF} qui est produite par ce modulateur 72 est automatiquement prise en compte par le démodulateur synchrone 93. Par exemple, cette modulation du courant I_{HF} peut consister à inverser le sens du courant I_{HF} à multiples reprises, selon une séquence temporelle aléatoire ou pseudo-aléatoire. De telles inversions de courant reviennent à multiplier le courant I_{HF} par des facteurs successifs chacun égaux à +1 ou -1, pendant des durées variables, et produisent un étalement spectral du courant I_{HF} tel que ce courant est délivré par le générateur 7.

Avantageusement, le signal qui est produit en sortie par le démodulateur synchrone 93 peut être amplifié avant d'être introduit dans le démodulateur synchrone 94.

Le démodulateur synchrone 94 reçoit donc en entrée le signal qui est produit par le démodulateur synchrone 93, après amplification éventuelle, et reçoit simultanément le signal CTRL BF qui est introduit dans le générateur 6. Il est adapté pour effectuer un transfert de fréquence sur le signal qui est produit par le démodulateur synchrone 93. De préférence, le démodulateur synchrone 94 peut être de type numérique. Lorsque le modulateur 62 est utilisé, la modulation du courant I_{BF} qui est produite par ce modulateur 62 est automatiquement prise en compte par le démodulateur synchrone 94.

De cette façon, les moyens de détection 9 produisent en sortie une tension continue qui est proportionnelle à l'amplitude de la composante à la fréquence HF-BF, contenue dans la tension qui existe entre les bornes secondaire S1 et S2. Cette composante à la fréquence HF-BF résulte du comportement non-linéaire du matériau superparamagnétique de l'échantillon 100. Du fait de ce comportement non-linéaire, la réponse du matériau superparamagnétique das noyaux 1N-4N aux excitations simultanées selon les deux fréquences HF et BF contient des signaux à des fréquences qui sont des combinaisons linéaires des deux fréquences HF et BF, avec des coefficients de combinaison linéaire qui sont entiers. Dans le cas présent, les démodulateurs synchrones 93 et 94 sélectionnent celle de ces combinaisons qui est la différence HF-BF. L'amplitude de la composante à cette fréquence HF-BF constitue le signal de détection, et peut être évaluée par un voltmètre.

La figure 3 illustre des modes de réalisation possibles pour les générateurs 5-7 qui sont particulièrement économiques, et une façon de les connecter aux bobines 1-4 qui permet d'améliorer le transfert d'énergie des générateurs 5-7 aux bobines 1-4.

Le générateur 5 de courant continu peut être formé par deux générateurs 5a et 5b qui sont identiques mais connectés respectivement aux bornes A et B de façon à pourvoir injecter le courant continu I_{DC} dans la chaîne des bobines de la borne A vers la borne B ou en sens contraire. Un seul des deux générateurs 5a et 5b est donc activé pour chaque mesure, en fonction du signe qui est voulu pour le courant I_{DC}. Chaque générateur 5a, 5b comprend deux commutateurs qui sont connectés en série entre les deux bornes (V_{DD} et masse) de la source 51. Un tel assemblage, désigné par la référence 54, est appelé couramment «bras de pont» dans le langage de l'Homme du métier. Il est destiné à une fonction de hachage. La borne intermédiaire entre les deux commutateurs de chaque générateur 5a, 5b est connectée à la sortie de ce générateur par l'intermédiaire du filtre 53. La commande des commutateurs par modulation de largeur d'impulsions, ou PWM pour «pulse width modulation» en anglais, permet d'ajuster la valeur absolue de l'intensité du courant continu I_{DC}. Les moyens 10 pour mesurer le courant I_{DC} sont avantageusement intercalés en série entre la sortie du générateur 5a et la borne A de la chaîne des bobines 1-4, et l'autre résistance 11 peut être intercalée en série entre la sortie du générateur 5b et la borne B de la chaîne des bobines 1-4.

Le générateur 6 de courant alternatif peut aussi être réalisé à partir d'un bras de pont, référencé 64, et d'un filtre adapté 65. Le bras de pont du générateur 6 peut aussi être alimenté par la source 51, et ses deux commutateurs sont commandés alternativement à la fréquence BF. Le filtre 65, noté filtre BF, sélectionne la composante fondamentale pour transmission en sortie à la borne centrale C.

Enfin, le générateur 7 de courant alternatif peut encore être réalisé à partir d'un bras de pont, référencé 74, et d'un filtre adapté 75. Le bras de pont du générateur 7 peut être alimenté de même par la source 51, et ses deux commutateurs sont commandés alternativement à la fréquence HF. Le filtre 75 sélectionne un intervalle spectral autour de la composante fondamentale pour transmission en sortie aux bornes secondaires S1 et S2. De façon connue, une telle constitution du générateur 7 permet de réaliser simplement la modulation par étalement spectral, en décalant d'une demi-période les impulsions de commande du bras de pont selon une séquence temporelle aléatoire.

Les sorties des générateurs 5a, 5b et 6 ainsi que les deux bornes extrêmes F et H de l'enroulement primaire 73 du transformateur 8, peuvent être connectées aux bornes A, B, C et S1, S2 par quatre câbles bifilaires CC1-CC4. Les quatre câbles CC1-CC4 sont avantageusement d'un même type, bifilaire ou coaxial, de préférence blindé et à impédance caractéristique maîtrisée. Ils sont connectés de la façon suivante :
- le premier fil du câble CC1 relie la sortie du générateur 5a à la borne A de la chaîne des bobines 1-4 ;
- le second fil du câble CC1 et le premier fil du câble CC2 sont connectés en parallèle pour relier la borne extrême F de l'enroulement primaire du transformateur 8 à la borne secondaire S1 de la chaîne des bobines 1-4, par l'intermédiaire du premier condensateur C2 ;
- le second fil du câble CC2 et le premier fil du câble CC3 sont connectés en parallèle pour relier la sortie G du générateur 6 à la borne centrale C de la chaîne des bobines 1-4, par l'intermédiaire du condensateur C1 ;
- le second fil du câble CC3 et le premier fil du câble CC4 sont connectés en parallèle pour relier la borne extrême H de l'enroulement primaire du transformateur 8 à la borne secondaire S2 de la chaîne des bobines 1-4, par l'intermédiaire du second condensateur C2 ; et
- le second fil du câble CC4 relie la sortie du générateur 5b à la borne B de la chaîne des bobines 1-4.

Alors, les longueurs respectives des câbles CC1-CC4 peuvent être sélectionnées avantageusement pour ajuster les impédances de connexion qui sont effectives pour le courant alternatif I_{HF}. Ainsi, il est possible d'augmenter l'énergie électrique qui est transférée par le générateur 7 aux bobines 1-4, à consommation équivalente de l'appareil.

Un appareil conforme à l'invention qui possède par exemple la configuration des bobines de la figure 1a, peut être utilisé de la façon suivante pour mesurer le champ magnétique **B.** L'ensemble des quatre bobines 1-4 est placé dans le champ magnétique à mesurer, avec de préférence l'axe commun des bobines qui est parallèle au champ magnétique. En l'absence de courant continu I_{DC} (ID_{C} = 0), les deux courants alternatifs I_{BF} et I_{HF} génèrent un signal de détection qui est non-nul en sortie du modulateur synchrone 94. L'intensité du courant continu I_{DC} est alors ajustée au moyen du convertisseur variable 52 pour annuler ce signal de détection. Eventuellement, cet ajustement peut être automatisé en asservissant une commande du convertisseur 52 à la sortie du démodulateur synchrone 94. La valeur du courant continu I_{DC} qui produit l'annulation du signal de détection est le résultat de mesure du champ magnétique. Elle peut être éventuellement convertie en unité de champ magnétique en connaissant relation numérique entre l'intensité du champ magnétique de compensation qui est produit par les bobines 1-4 et l'intensité du courant continu I_{DC}.

Mais un appareil qui est conforme à l'invention peut aussi être utilisé pour mesurer un courant continu I qui est inconnu. Le courant inconnu I est alors mesuré par l'intermédiaire du champ magnétique qu'il génère. Ce champ magnétique est mesuré de la façon qui vient d'être décrite, et la valeur du courant inconnu est déduite de la valeur qui a été mesurée pour le champ magnétique, connaissant la trajectoire du courant inconnu I et les positions des bobines 1-4 par rapport à cette trajectoire. L'Homme du métier, notamment compétent en magnétostatique, sait relier la valeur mesurée pour le champ magnétique à la valeur de l'intensité du courant inconnu I. Avantageusement, les bobines 1-4 sont disposées par rapport à la trajectoire du courant inconnu I d'une façon qui est adaptée à la forme des lignes de champ magnétique, et pour avoir une relation numérique simple entre la valeur du courant inconnu I et celle du champ magnétique mesuré. Les configurations des figures 1b et 1c sont particulièrement adaptées pour cela.

Il est entendu que l'invention peut être reproduite en modifiant des aspects secondaires de celle-ci par rapport à la description détaillée qui a été donnée ci-dessus, tout en conservant certains au moins des avantages cités. Parmi ces modifications, on peut citer de façon non-limitative :
- les positions et orientations relatives des quatre bobines 1-4 peuvent être changées ;
- l'utilisation des modulateurs 62 et 72 peut être combinée avec la réalisation des générateurs 6 et 7 à partir de bras de ponts ;
- les générateurs 5, 6 et 7 peuvent avoir des constitutions différentes de celles décrites en relation avec les figures 2 et 3 ; et
- le mélange de fréquences qui est sélectionné par les moyens de détection 9 pour obtenir le signal de mesure, peut être une combinaison linéaire des fréquences BF et HF autre que la différence HF-BF et la somme HF+BF.

## Revendications

1. Appareil pour mesurer un champ magnétique, comprenant :
- quatre bobines (1-4) de fil électrique à noyaux magnétiques non-linéaires sans hystérèse, dits noyaux superparamagnétiques (1N-4N), les quatre bobines à noyaux possédant des géométries et des propriétés électriques et électromagnétiques qui sont identiques ou sensiblement identiques, et étant connectées électriquement en série de façon à former une chaîne avec deux bornes extrêmes (A, B) de ladite chaîne, une borne centrale (C) dans ladite chaîne, et deux bornes secondaires (S1, S2) de ladite chaîne qui sont situées chacune entre la borne centrale et l'une des deux bornes extrêmes ;
- des moyens (5) d'injection d'un courant continu (I_{DC}) dans la chaîne des bobines, connectés aux deux bornes extrêmes (A, B) de la chaîne des bobines (1-4), et des moyens d'ajustement d'une intensité du courant continu ;
- des moyens (6) d'injection d'un premier courant alternatif (I_{BF}) ayant une première fréquence (BF), connectés pour injecter ledit premier courant alternatif dans la chaîne des bobines (1-4) par la borne centrale (C), et pour reprendre ledit premier courant alternatif par les deux bornes extrêmes (A, B), de sorte que le premier courant alternatif s'écoule avec des premières intensités qui sont identiques ou sensiblement identiques par lesdites deux bornes extrêmes sans s'écouler par les bornes secondaires (S1, S2) ;
- des moyens (7) d'injection d'un second courant alternatif (I_{HF}) ayant une seconde fréquence (HF) différente de la première fréquence (BF), connectés pour injecter ledit second courant alternatif dans la chaîne des bobines (1-4) par les deux bornes secondaires (S1, S2), et pour reprendre ledit second courant alternatif par la borne centrale (C) et les deux bornes extrêmes (A, B) de sorte que le second courant alternatif s'écoule avec des secondes intensités qui sont identiques ou sensiblement identiques par lesdites deux bornes secondaires, et de sorte que ledit second courant alternatif s'écoule avec des troisièmes intensités qui sont identiques ou sensiblement identiques dans toutes les bobines mais en sens contraires entre deux bobines qui sont successives dans la chaîne ; et
- des moyens (9) de détection d'au moins une composante de tension électrique qui existe entre les deux bornes secondaires (S1, S2) de la chaîne des bobines (1-4), une fréquence de ladite composante de tension électrique, dite fréquence de mélange, étant une combinaison linéaire de la première fréquence (BF) et de la seconde fréquence (HF), avec des coefficients de combinaison linéaire fixes, entiers et non nuls,
ledit appareil étant adapté pour activer simultanément les moyens d'injection (6, 7) des premier (I_{BF}) et second (I_{HF}) courants alternatifs, et pour ajuster l'intensité du courant continu (I_{DC}) de façon à annuler une amplitude de la composante de tension électrique qui possède la fréquence de mélange, pendant que lesdits premier et second courants alternatifs sont injectés,
de sorte que lorsque les quatre bobines (1-4) sont placées dans le champ magnétique, une valeur de l'intensité du courant continu (I_{DC}) qui annule l'amplitude de la composante de tension électrique possédant la fréquence de mélange, soit proportionnelle à une intensité du champ magnétique.

2. Appareil selon la revendication 1, dans lequel un quotient entre les première (BF) et seconde (HF) fréquences est supérieur à 10.

3. Appareil selon la revendication 1 ou 2, dans lequel les moyens d'injection (5) du courant continu (I_{DC}), les moyens (6) d'injection du premier courant alternatif (I_{BF}) et les moyens (7) d'injection du second courant alternatif (I_{HF}) comprennent ensemble quatre câbles de connexion (CC1-CC4) qui sont dédiés respectivement à chacune des quatre bobines (1-4), chaque câble comprenant deux fils électriques connectés un-à-une aux deux bornes successives dans la chaîne des bobines qui connectent directement la bobine à laquelle ledit câble est dédié, de sorte que tout le courant continu (I_{DC}), tout le premier courant alternatif (I_{BF}) et tout le second courant alternatif (I_{HF}) qui sont injectés dans les bobines (1-4) soient transportés en aller et retour par lesdits câbles, et des longueurs respectives des dits câbles sont ajustées pour que les troisièmes intensités du second courant alternatif soient identiques ou sensiblement identiques en valeur absolue dans toutes les bobines de la chaîne.

4. Appareil selon l'une quelconque des revendications précédentes, dans lequel la seconde fréquence (HF) est supérieure à la première fréquence (BF),
et dans lequel les moyens (7) d'injection du second courant alternatif (I_{HF}) comprennent une source (71) du second courant alternatif et un enroulement primaire (73) d'un transformateur (8), une sortie de courant de ladite source étant connectée à un point milieu (J) de l'enroulement primaire du transformateur, et deux bornes extrêmes (F, H) dudit enroulement primaire étant connectées respectivement aux deux bornes secondaires (S1, S2) de la chaîne des bobines (1-4),
et dans lequel un enroulement secondaire (91) du transformateur (8) appartient aux moyens (9) de détection de la composante de tension électrique qui possède la fréquence de mélange.

5. Appareil selon l'une quelconque des revendications précédentes, dans lequel les moyens (9) de détection de la composante de tension électrique qui possède la fréquence de mélange comprennent :
- un premier démodulateur synchrone (93) qui est couplé aux moyens (7) d'injection du second courant alternatif (I_{HF}), et qui est agencé pour décaler en fréquence la composante de tension électrique qui possède la fréquence de mélange, par suppression d'une contribution de la seconde fréquence (HF) dans ladite fréquence de mélange ; et
- un second démodulateur synchrone (94) qui est couplé aux moyens (6) d'injection du premier courant alternatif (I_{BF}), et qui est agencé pour décaler en fréquence la composante de tension électrique qui possède la fréquence de mélange, par suppression d'une contribution de la première fréquence (BF) dans ladite fréquence de mélange,
lesdits premier (93) et second (94) démodulateurs synchrones étant agencés en cascade de façon à produire en sortie un signal électrique continu qui est proportionnel à l'amplitude de la composante de tension électrique qui possède la fréquence de mélange.

6. Appareil selon l'une quelconque des revendications précédentes, dans lequel la seconde fréquence (HF) est supérieure à la première fréquence (BF),
et les moyens (6) d'injection du premier courant alternatif (I_{BF}) sont connectés à la borne centrale (C) de la chaîne des bobines (1-4) par un premier condensateur (C1) qui est adapté pour être conducteur de courant alternatif à la première fréquence (BF) et à la seconde fréquence (HF) ;
et les moyens (7) d'injection du second courant alternatif (I_{HF}) sont connectés à chacune des deux bornes secondaires (S1, S2) de la chaîne des bobines (1-4) par un second condensateur (C2) respectif qui est adapté pour être conducteur de courant alternatif à la seconde fréquence (HF) mais pas à la première fréquence (BF).

7. Appareil selon l'une quelconque des revendications 1 à 6, adapté pour que les quatre bobines (1-4) soient toutes parallèles à un axe commun, soient juxtaposées les unes aux autres et aient des sens d'enroulement respectifs du fil électrique autour des noyaux (1N-4N) qui sont identiques par rapport audit axe commun.

8. Appareil selon l'une quelconque des revendications 1 à 6, adapté pour que les quatre bobines (1-4) soient toutes parallèles à un axe commun, et soient réparties en deux paires de bobines, avec les bobines d'une même paire (1, 2) ayant des sens d'enroulement du fil électrique autour des noyaux qui sont identiques pour les deux bobines de ladite paire, et inverses au sens d'enroulement des bobines de l'autre paire (3, 4), et avec les bobines d'une même paire qui sont juxtaposées alors que les deux paires de bobines sont distantes l'une de l'autre perpendiculairement audit axe commun.

9. Appareil selon l'une quelconque des revendications 1 à 6, dans lequel chaque noyau (1N-4N) est en forme de boucle fermée et chaque bobine (1-4) est enroulée sur le noyau de ladite bobine perpendiculairement à une direction longitudinale de la boucle, et les quatre bobines à noyaux sont juxtaposées les unes aux autres sur toute une longueur de boucle des noyaux, et ont des sens d'enroulement du fil électrique qui sont identiques.

10. Procédé de mesure d'un champ magnétique, comprenant les étapes suivantes :
/1/ placer les quatre bobines (1-4) d'un appareil conforme à l'une quelconque des revendications 1 à 8, dans un champ magnétique ; et
/2/ activer simultanément les moyens d'injection (6, 7) des premier (I_{BF}) et second (I_{HF}) courants alternatifs, et ajuster l'intensité du courant continu (I_{DC}) qui est produite par les moyens d'injection de courant continu, de façon à annuler l'amplitude de la composante de tension électrique qui possède la fréquence de mélange, pendant que lesdits premier et second courants alternatifs sont injectés ;
la valeur de l'intensité du courant continu (I_{DC}) qui est produite par lesdits moyens (5) d'injection de courant continu et qui a été ajustée à l'étape /2/ constituant un résultat de mesure pour le champ magnétique.

11. Procédé de mesure d'un courant électrique continu, comprenant les étapes suivantes :
/1/ fournir un appareil conforme à l'une quelconque des revendications 1 à 9 ;
/2/ disposer les quatre bobines (1-4) à proximité du courant électrique continu qui est à mesurer, appelé courant inconnu (I), ou bien autour dudit courant inconnu de sorte que ledit courant inconnu passe à travers les boucles des quatre noyaux (1N-4N) à l'extérieur des bobines ; et
/3/ activer simultanément les moyens d'injection (6, 7) des premier (I_{BF}) et second (I_{HF}) courants alternatifs, et ajuster l'intensité du courant continu (I_{DC}) qui est produit par les moyens (5) d'injection de courant continu dans la chaîne des bobines (1-4), de façon à annuler l'amplitude de la composante de tension électrique qui possède la fréquence de mélange, pendant que lesdits premier et second courants alternatifs sont injectés ;
la valeur de l'intensité du courant continu (I_{DC}) qui est produite par lesdits moyens (5) d'injection de courant continu et qui a été ajustée à l'étape /3/, constituant un résultat de mesure pour le courant inconnu (I).

## Patentansprüche

1. Vorrichtung zur Messung eines Magnetfelds, aufweisend:
- vier Spulen (1-4) aus elektrischem Draht, mit nichtlinearen Magnetkernen ohne Hysterese, superparamagnetische Kerne (1N-4N) genannt, wobei die vier mit Kernen versehene Spulen jeweilige Geometrien und elektrische und elektromagnetische Eigenschaften haben, die identisch oder im Wesentlichen identisch sind, und elektrisch in Serie verbunden sind, um eine Kette mit zwei Endanschlüssen (A, B) der Kette, einem zentralen Anschluss (C) in der Kette und zwei Sekundäranschlüssen (S1, S2) der Kette, die sich jeweils zwischen dem zentralen Anschluss und einem der Endanschlüsse befinden, zu bilden,
- Einrichtungen (5) zum Einspeisen eines Gleichstroms (I_{DC}) in die Kette der Spulen, die mit den zwei Endanschlüssen (A, B) der Kette der Spulen (1-4) verbunden sind, und Anpassungseinrichtungen zum Anpassen einer Intensität des Gleichstroms;
- Einrichtungen (6) zum Einspeisen eines ersten Wechselstroms (I_{BF}) einer ersten Frequenz (BF), die verbunden sind, um den ersten Wechselstrom in die Kette der Spulen (1-4) über den zentralen Anschluss (C) einzuspeisen und um den ersten Wechselstrom über die zwei Endanschlüsse (A, B) wieder aufzunehmen, so dass der erste Wechselstrom mit ersten Intensitäten, die identisch oder im Wesentlichen identisch sind, über die zwei Endanschlüsse fließt, ohne über die zwei Sekundäranschlüsse (S1, S2) zu fließen;
- Einrichtungen (7) zum Einspeisen eines zweiten Wechselstroms (I_{HF}) einer sich von der ersten Frequenz (BF) unterscheidenden zweiten Frequenz (HF), die verbunden sind, um den zweiten Wechselstrom in die Kette der Spulen (1-4) über die zwei Sekundäranschlüsse (S1, S2) einzuspeisen und um den zweiten Wechselstrom über den zentralen Anschluss (C) und die zwei Endanschlüsse (A, B) wieder aufzunehmen, so dass der zweite Wechselstrom mit zweiten Intensitäten, die identisch oder im Wesentlichen identisch sind, über die zwei Sekundäranschlüsse fließt, und so dass der zweite Wechselstrom mit dritten Intensitäten, die identisch oder im Wesentlichen identisch sind, in allen Spulen fließt, aber in entgegengesetzten Richtungen zwischen zwei Spulen, die in der Kette aufeinanderfolgend sind; und
- Detektionseinrichtungen (9) zum Detektieren mindestens einer elektrischen Spannungskomponente, die zwischen den zwei Sekundäranschlüssen (S1, S2) der Kette der Spulen (1-4) vorhanden ist, wobei eine Frequenz der elektrischen Spannungskomponente, Mischfrequenz genannt, eine lineare Kombination der ersten Frequenz (BF) und der zweiten Frequenz (HF) ist, und wobei Koeffizienten der linearen Kombination fest, ganzzahlig und ungleich null sind,
wobei die Vorrichtung angepasst ist, die den ersten (I_{BF}) und den zweiten (I_{HF}) Wechselstrom einspeisenden Einrichtungen (6, 7) gleichzeitig zu aktivieren und die Intensität des Gleichstroms (I_{DC}) derart anzupassen, dass eine Amplitude der elektrischen Spannungskomponente, die die Mischfrequenz besitzt, während der Einspeisung des ersten und zweiten Wechselstroms annulliert ist,
so dass, wenn die vier Spulen (1-4) in dem Magnetfeld angeordnet sind, ein Wert der Intensität des Gleichstroms (I_{DC}), der die elektrische Spannungskomponente, die die Mischfrequenz besitzt, annulliert, proportional zu einer Intensität des Magnetfelds ist.

2. Vorrichtung nach Anspruch 1, in welcher ein Quotient zwischen der ersten (BF) und zweiten (HF) Frequenz größer als 10 ist.

3. Vorrichtung nach Anspruch 1 oder 2, in welcher die den Gleichstrom (I_{DC}) einspeisenden Einrichtungen (5), die den ersten Wechselstrom (I_{BF}) einspeisenden Einrichtungen (6) und die den zweiten Wechselstrom (I_{HF}) einspeisenden Einrichtungen (7) insgesamt vier Anschlusskabel (CC1-CC4) aufweisen, die jeweils einer der vier Spulen (1-4) zugeordnet sind, wobei jedes Kabel zwei elektrische Drähte aufweist, die eins-zu-eins mit zwei aufeinanderfolgenden Anschlüssen in der Kette der Spulen verbunden sind, die die Spule, der das Kabel zugeordnet ist, direkt verbinden, so dass der gesamte Gleichstrom (I_{DC}), der gesamte erste Wechselstrom (I_{BF}) und der gesamte zweite Wechselstrom (I_{HF}), die in die Spulen (1-4) eingespeist werden, im Vor- und Rückgang von den Kabeln transportiert werden, und jeweilige Längen der Kabel angepasst sind, damit in allen Spulen der Kette die dritten Intensitäten des zweiten Wechselstroms in ihrem Absolutwert identisch oder im Wesentlichen identisch sind.

4. Vorrichtung nach einem der vorstehenden Ansprüche, in welcher die zweite Frequenz (HF) höher als die erste Frequenz (BF) ist,
und in welcher die den zweiten Wechselstrom (I_{HF}) einspeisenden Einrichtungen (7) eine Quelle (71) des zweiten Wechselstroms und eine Primärwicklung (73) eines Transformators (8) aufweisen, wobei ein Stromausgang der Quelle mit einem Mittelpunkt (J) der Primärwicklung des Transformators verbunden ist und zwei Endanschlüsse (F, H) der Primärwicklung jeweils mit den zwei Sekundäranschlüssen (S1, S2) der Kette der Spulen (1-4) verbunden sind,
und in welcher eine Sekundärwicklung (91) des Transformators (8) Teil der Detektionseinrichtungen (9) ist, die die elektrische Spannungskomponente, die die Mischfrequenz besitzt, detektieren.

5. Vorrichtung nach einem der vorstehenden Ansprüche, in welcher die Detektionseinrichtungen (9), die die elektrische Spannungskomponente, die die Mischfrequenz besitzt, detektieren, aufweisen:
- einen ersten synchronen Demodulator (93), der mit den den zweiten Wechselstrom (I_{HF}) einspeisenden Einrichtungen (7) gekoppelt ist und der konfiguriert ist, eine Frequenzverschiebung an der elektrischen Spannungskomponente, die die Mischfrequenz besitzt, durch Unterdrückung eines Beitrags der zweiten Frequenz (HF) in der Mischfrequenz durchzuführen,
- einen zweiten synchronen Demodulator (94), der mit den den ersten Wechselstrom (I_{BF}) einspeisenden Einrichtungen (6) gekoppelt ist und der konfiguriert ist, eine Frequenzverschiebung an der elektrischen Spannungskomponente, die die Mischfrequenz besitzt, durch Unterdrückung eines Beitrags der ersten Frequenz (BF) in der Mischfrequenz durchzuführen; und
wobei der erste (93) und zweite (94) synchrone Demodulator kaskadenförmig angeordnet sind, um am Ausgang ein kontinuierliches elektrisches Signal zu erzeugen, das proportional zu der Amplitude der elektrischen Spannungskomponente, die die Mischfrequenz besitzt, ist.

6. Vorrichtung nach einem der vorstehenden Ansprüche, in welcher die zweite Frequenz (HF) höher als die erste Frequenz (BF) ist,
und die den ersten Wechselstrom (I_{BF}) einspeisenden Einrichtungen (6) mit dem zentralen Anschluss (C) der Kette der Spulen (1-4) über einen ersten Kondensator (C1) verbunden sind, der eingerichtet ist, bei der ersten Frequenz (BF) und der zweiten Frequenz (HF) Wechselstromleiter zu sein;
und die den zweiten Wechselstrom (I_{HF}) einspeisenden Einrichtungen (7) mit jedem der Sekundäranschlüsse (S1, S2) der Kette der Spulen (1-4) über einen jeweiligen zweiten Kondensator (C2) verbunden sind, der eingerichtet ist, bei der zweiten Frequenz (HF) Wechselstromleiter zu sein, aber nicht bei der ersten Frequenz (BF).

7. Vorrichtung nach einem der vorstehenden Ansprüche 1 bis 6, die so eingerichtet ist, dass alle vier Spulen (1-4) parallel zu einer gemeinsamen Achse sind, nebeneinander angeordnet sind und jeweilige Wicklungsrichtungen des elektrischen Drahts um die Kerne (1N-4N) haben, die bezüglich der gemeinsamen Achse gleich sind.

8. Vorrichtung nach einem der vorstehenden Ansprüche 1 bis 6, die so eingerichtet ist, dass alle vier Spulen (1-4) parallel zu einer gemeinsamen Achse sind und auf zwei Spulenpaare verteilt sind, wobei die Spulen eines gleichen Paars (1, 2) Wicklungsrichtungen des elektrischen Drahts um die Kerne haben, die für die zwei Spulen dieses Paars identisch sind und umgekehrt zu der Wicklungsrichtung der Spulen des anderen Paars (3, 4) sind, und wobei die Spulen eines gleichen Paars nebeneinander angeordnet sind, während senkrecht zu der gemeinsamen Achse die zwei Spulenpaare voneinander beabstandet sind.

9. Vorrichtung nach einem der Ansprüche 1 bis 6, in welcher jeder Kern (1N-4N) in Form einer geschlossenen Schleife ist und jede Spule (1-4) senkrecht zu einer Längsrichtung der Schleife auf den Kern der Spule gewickelt ist, und die vier mit Kernen versehenen Spulen über eine gesamte Länge der Kerne nebeneinander angeordnet sind und Wicklungsrichtungen des elektrischen Drahts haben, die identisch sind.

10. Verfahren zur Messung eines Magnetfelds, aufweisend die folgenden Schritte:
/1/ Anordnen der vier Spulen (1-4) einer Vorrichtung nach einem der Ansprüche 1 bis 8 in einem Magnetfeld; und
/2/ gleichzeitiges Aktivieren der den ersten (I_{BF}) und zweiten (I_{HF}) Wechselstrom einspeisenden Einrichtungen (6, 7) und Anpassen der Intensität des Gleichstroms (I_{DC}), der von den den Gleichstrom einspeisenden Einrichtungen erzeugt wird, derart, dass die Amplitude der elektrischen Spannungskomponente, die die Mischfrequenz besitzt, während der Einspeisung des ersten und zweiten Wechselstroms annulliert ist;
wobei der Wert der Intensität des Gleichstroms (I_{DC}), die von den den Gleichstrom einspeisenden Einrichtungen (5) erzeugt wird und die im Schritt /2/ angepasst worden ist, ein Messergebnis für das Magnetfeld bildet.

11. Verfahren zur Messung eines elektrischen Gleichstroms, aufweisend die folgenden Schritte:
/1/ Bereitstellen einer Vorrichtung nach einem der Ansprüche 1 bis 9;
/2/ Anordnen der vier Spulen (1-4) in der Nähe des elektrischen Gleichstroms, der zu messen ist, unbekannter Strom (I) genannt, oder um den unbekannten Strom herum, so dass der unbekannte Strom die Schleifen der vier Kerne (1N-4N) außerhalb der Spulen durchläuft; und
/3/ gleichzeitiges Aktivieren der den ersten (I_{BF}) und zweiten (I_{HF}) Wechselstrom einspeisenden Einrichtungen (6, 7) und Anpassen der Intensität des Gleichstroms (I_{DC}), der von den den Gleichstrom in die Kette der Spulen (1-4) einspeisenden Einrichtungen erzeugt wird, derart, dass die Amplitude der elektrischen Spannungskomponente, die die Mischfrequenz besitzt, während der Einspeisung des ersten und zweiten Wechselstroms annulliert ist;
wobei der Wert der Intensität des Gleichstroms (I_{DC}), der von den den Gleichstrom einspeisenden Einrichtungen (5) erzeugt wird und die im Schritt /3/ angepasst worden ist, ein Messergebnis für den unbekannten Strom (I) bildet.

## Claims

1. Device for measuring a magnetic field, comprising:
- four coils (1-4) of electrical wire with non-linear magnetic cores devoid of hysteresis, called superparamagnetic cores (1N-4N), the four cored coils having identical or substantially identical geometries and electrical and electromagnetic properties, and being electrically connected in series so as to form a chain with two end terminals (A, B) of said chain, a central terminal (C) in said chain, and two secondary terminals (S1, S2) of said chain that are each located between the central terminal and one of the two end terminals;
- means (5) for injecting a direct current (I_{DC}) into the chain of coils, connected to the two end terminals (A, B) of the chain of coils (1-4), and means for adjusting an intensity of the direct current;
- means (6) for injecting a first alternating current (I_{LF}) having a first frequency (LF), connected in order to inject said first alternating current into the chain of coils (1-4) via the central terminal (C), and to recover said first alternating current via the two end terminals (A, B), so that the first alternating current flows with first intensities that are identical or substantially identical via said two end terminals without flowing via the secondary terminals (S1, S2);
- means (7) for injecting a second alternating current (I_{HF}) having a second frequency (HF) different from the first frequency (LF), connected in order to inject said second alternating current into the chain of coils (1-4) via the two secondary terminals (S1, S2), and to recover said second alternating current via the central terminal (C) and the two end terminals (A, B) so that the second alternating current flows with second intensities that are identical or substantially identical via the two secondary terminals, and in such a way that said second alternating current flows with third intensities that are identical or substantially identical in all of the coils but in opposite directions between two coils that are successive in the chain; and
- means (9) for detecting at least one voltage component that exists between both secondary terminals (S1, S2) of the chain of coils (1-4), a frequency of said voltage component, called mixing frequency, being a linear combination of the first frequency (LF) and the second frequency (HF), with linear combination coefficients that are fixed non-zero integers,
said device being suitable for simultaneously activating the means (6, 7) for injecting the first (I_{LF}) and second (I_{HF}) alternating currents, and for adjusting the intensity of the direct current (I_{DC}) so as to cancel an amplitude of the voltage component that has the mixing frequency, while said first and second alternating currents are injected,
so that when the four coils (1-4) are placed in the magnetic field, a value of the intensity of the direct current (I_{DC}) that cancels the amplitude of the voltage component having the mixing frequency is proportional to an intensity of the magnetic field.

2. Device according to claim 1, wherein a quotient between the first (LF) and second (HF) frequencies is greater than 10.

3. Device according to claim 1 or 2, wherein the means (5) for injecting the direct current (I_{DC}), the means (6) for injecting the first alternating current (I_{LF}) and the means (7) for injecting the second alternating current (I_{HF}) together comprise four connection cables (CC1-CC4) that are respectively dedicated to each of the four coils (1-4), each cable comprising two electrical wires connected one-by-one to the two successive terminals in the chain of coils that directly connect the coil to which said cable is dedicated, so that all of the direct current (I_{DC}), all of the first alternating current (I_{LF}) and all of the second alternating current (I_{HF}) that are injected into the coils (1-4) are transported out and back by said cables, and respective lengths of said cables are adjusted so that the third intensities of the second alternating current are identical or substantially identical in absolute values in all of the coils in the chain.

4. Device according to any one of the preceding claims, wherein the second frequency (HF) is higher than the first frequency (LF),
and wherein the means (7) for injecting the second alternating current (I_{HF}) comprise a source (71) of the second alternating current and a primary winding (73) of a transformer (8), a current output of said source being connected to a middle point (J) of the primary winding of the transformer, and two end terminals (F, H) of said primary winding being connected respectively to the two secondary terminals (S1, S2) of the chain of coils (1-4),
and wherein a secondary winding (91) of the transformer (8) belongs to the means (9) for detecting the voltage component that has the mixing frequency.

5. Device according to any one of the preceding claims, wherein the means (9) for detecting the voltage component that has the mixing frequency comprise:
- a first synchronous demodulator (93) that is coupled to the means (7) for injecting the second alternating current (I_{HF}), and which is arranged to offset the frequency of the voltage component that has the mixing frequency, by suppressing a contribution of the second frequency (HF) to said mixing frequency; and
- a second synchronous demodulator (94) that is coupled to the means (6) for injecting the first alternating current (I_{LF}), and which is arranged to offset the frequency of the voltage component that has the mixing frequency, by suppressing a contribution of the first frequency (LF) to said mixing frequency,
said first (93) and second (94) synchronous demodulators being arranged in cascade so as to output a direct electrical signal output that is proportional to the amplitude of the voltage component that has the mixing frequency.

6. Device according to any one of the preceding claims, wherein the second frequency (HF) is higher than the first frequency (LF),
and the means (6) for injecting the first alternating current (I_{LF}) are connected to the central terminal (C) of the chain of coils (1-4) by a first capacitor (C1) that is suitable for conducting alternating current at the first frequency (LF) and at the second frequency (HF);
and the means (7) for injecting the second alternating current (I_{HF}) are connected to each of both secondary terminals (S1, S2) of the chain of coils (1-4) by a respective second capacitor (C2) that is suitable for conducting alternating current at the second frequency (HF) but not at the first frequency (LF).

7. Device according to any one of claims 1 to 6, arranged so that the four coils (1-4) are all parallel to a common axis, juxtaposed to one another and have respective winding directions of the electrical wire around the cores (1N-4N) that are identical with respect to said common axis.

8. Device according to any one of claims 1 to 6, arranged so that the four coils (1-4) are all parallel to a common axis and are split into two pairs of coils, with the coils in one and same pair (1, 2) having winding directions of the electrical wire around the cores that are identical for the two coils in said pair, and opposite to the winding direction of the coils in the other pair (3, 4), and with the coils in one and same pair being juxtaposed whereas the two pairs of coils are apart from each other perpendicular to said common axis.

9. Device according to any one of claims 1 to 6, wherein each core (1N-4N) is in a form of a closed loop and each coil (1-4) is wound around the core of said coil perpendicular to a longitudinal direction of the loop, and the four cored coils are juxtaposed to one another over an entire loop length of the cores, and have identical electrical wire winding directions.

10. Method for measuring a magnetic field, comprising the following steps:
/1/ placing the four coils (1-4) of a device according to any one of claims 1 to 8 in a magnetic field; and
/2/ simultaneously activating the means (6, 7) for injecting the first (I_{LF}) and second (I_{HF}) alternating currents, and adjusting the intensity of the direct current (I_{DC}) that is produced by the means for injecting the direct current so as to cancel the amplitude of the voltage component that has the mixing frequency, while said first and second alternating currents are injected;
the value of the intensity of the direct current (I_{DC}) that is produced by said direct current injection means (5), which was adjusted in step /2/, constituting a measurement result for the magnetic field.

11. Method for measuring a direct electrical current, comprising the following steps:
/1/ providing a device according to any one of claims 1 to 9;
/2/ arranging the four coils (1-4) near the direct electrical current to be measured, called the unknown current (I), or around said unknown current so that said unknown current passes through the loops of the four cores (1N-4N) outside the coils; and
/3/ simultaneously activating the means (6, 7) for injecting the first (I_{LF}) and second (I_{HF}) alternating currents, and adjusting the intensity of the direct current (I_{DC}) that is produced by the means (5) for injecting the direct current into the chain of coils (1-4) so as to cancel the amplitude of the voltage component that has the mixing frequency, while said first and second alternating currents are injected;
the value of the intensity of the direct current (I_{DC}) that is produced by said direct current injection means (5), which was adjusted in step /3/, constituting a measurement result for the unknown current (I).
